(19) Europäisches Patentamt
European Patent Office
Office européen des brevets

(11) EP 4 580 048 A1

(12) **DEMANDE DE BREVET EUROPEEN**

(43) Date de publication:
**02.07.2025 Bulletin 2025/27**

(21) Numéro de dépôt: **24222910.2**

(22) Date de dépôt: **23.12.2024**

(51) Classification Internationale des Brevets (IPC):
***H03D 7/14*** *(2006.01)* ***H03D 7/16*** *(2006.01)*
***H03H 19/00*** *(2006.01)*

(52) Classification Coopérative des Brevets (CPC):
**H03D 7/1466; H03D 7/165; H03H 19/002;**
H03D 2200/0082; H03D 2200/0086

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **27.12.2023 FR 2315348**

(71) Demandeurs:
- **Commissariat à l'Energie Atomique et aux Energies Alternatives
75015 Paris (FR)**
- **Institut Polytechnique de Grenoble
38000 Grenoble (FR)**
- **Centre National de la Recherche Scientifique
75016 Paris (FR)**
- **Université Grenoble Alpes
38400 Saint-Martin-d'Hères (FR)**

(72) Inventeurs:
- **MORCHE, Dominique
38054 GRENOBLE CEDEX 09 (FR)**
- **BOURDEL, Sylvain
38950 SAINT MARTIN LE VINOUX (FR)**
- **PODEVIN, Florence
38380 SAINT PIERRE DE CHARTREUSE (FR)**
- **BENDJEDDOU, Imadeddine
38054 GRENOBLE Cedex 09 (FR)**

(74) Mandataire: **Atout PI Laplace
Immeuble Up On
25 Boulevard Romain Rolland
CS 40072
75685 Paris Cedex 14 (FR)**

(54) **DISPOSITIF RADIOFRÉQUENCE DE TYPE NPF**

(57) Dispositif RadioFréquence (10) de type NPF comprenant une première borne d'extrémité E1, quatre premières branches nommées $BR1_0$, $BR1_1$, $BR1_2$, $BR1_3$ reliées à E1 et comportant chacune :
- une capacité, respectivement $C_0$, $C_1$, $C_2$, $C_3$, de même capacitance, comportant une première borne et une deuxième borne reliée à la masse, et
- un interrupteur disposé entre E1 et la première borne de la capacité de ladite première branche ;
ledit dispositif (10) étant adapté pour, dans chaque première branche $BR1_i$, fermer l'interrupteur à chaque instant $pT_0 + (i)\, T_0/4$, pendant $T_0/4$, avec p entier naturel et $T_0$ période du signal d'horloge ;
le dispositif comprenant au moins deux deuxièmes branches successives parmi un ensemble ordonné de deuxièmes branches $BR2_0$, $BR2_1$, $BR2_2$, $BR2_3$, la deuxième branche $BR2_i$ comprenant une deuxième borne d'extrémité $E2_i$, et
chaque deuxième branche du dispositif $BR2_k$ comprenant, pour chaque première branche, $BR1_i$, i = 0 à 3, un interrupteur entre la première borne de la capacité $C_i$ et ladite deuxième branche, ledit dispositif étant adapté pour fermer ledit interrupteur à chaque $pT_0 + (i + k)\, T_0/4$, pendant $T_0/4$.

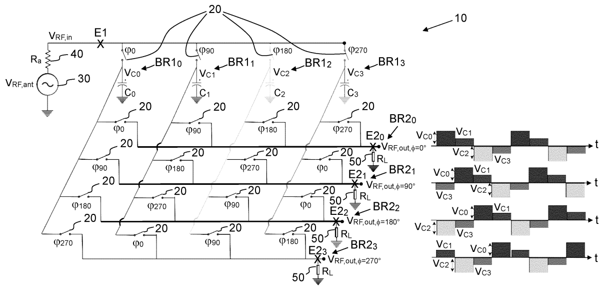


FIG.6



EP 4 580 048 A1

## Description

### Domaine technique :

L'invention se situe dans le domaine des dispositifs générateurs IQ différentiels (ou combineurs IQ différentiels) aux fréquences radiofréquences (RF), i.e. par exemple 0,1-5GHz ou au-delà.

Comme il est connu et illustré sur la figure 11, partie gauche, la fonction type d'un générateur IQ est la suivante : un générateur IQ reçoit un signal d'entrée, $V_{RF,ant}$ et permet d'obtenir en sortie deux signaux en quadrature (signaux complexes, fournissant une représentation complexe du signal d'entrée), dits $I^+$ et $Q^+$, de même fréquence et déphasés de 90° : $I^+ = V_{RF,out,0°}$ et $Q^+ = V_{RF,out,90°}$ (générateur type 81) ou quatre signaux dans le cas de générateur IQ différentiel avec, en plus, $I^- = -V_{RF,out,0°} = V_{RF,out,180°}$ et $Q^- = -V_{RF,out,90°} = V_{RF,out,270°}$ (générateur type 81').

Par voie de réciprocité, la fonction d'un tel dispositif peut être inversée, en échangeant entrée(s) et sortie(s) : on obtient alors un combineur IQ type 82 (possiblement différentiel type 82') comme illustré sur la figure 11 partie droite. Un tel combineur IQ (encore appelé en anglais « IQ Combiner ») reçoit en entrées deux signaux en quadrature de même fréquence et déphasés de 90° (signaux complexes) : $I^+ = V_{RF,in,0°}$ et $Q^+ = V_{RF,in,90°}$ (combineur 82) ou quatre signaux dans le cas du combineur IQ différentiel avec, en plus, $I^{\sim} = -V_{RF,in,0°} = V_{RF,in,18\,0°}$ et $Q^- = -V_{RF,in,90°} = V_{RF,in,270°}$ (combineur 82'), les combine et délivre le signal $V_{RF,out}$.

### Technique antérieure :

J. Kaukovuori, K. Stadius, J. Ryynanen, et K. A. I. Halonen, « Analysis and Design of Passive Polyphase Filters », IEEE Transactions on Circuits and Systems I: Regular Papers, vol. 55, no 10, p. 3023-3037, nov. 2008, doi: 10.1109/TCSI.2008.917990, propose, tel que représenté sur la figure 1, deux filtres polyphasés, PPF-I et PPF-II, permettant de générer des signaux en quadrature $I$ et Q différentiels ($I^+$, $I^-$, $Q^+$, $Q^-$). Chacun des filtres présente 4 chemins.

Toutefois, ces architectures PPF ont les défauts suivants :

- elles ne présentent pas, ou peu, de sélectivité fréquentielle du signal radiofréquence traité, ce qui rend les récepteurs associés sensibles aux bloqueurs dans le cas où le signal d'entrée est le signal reçu par un récepteur RF ;
- elles sont non agiles en fréquence ;
- elles sont encombrantes ;
- elles présentent théoriquement au moins 3dB de pertes entre l'entrée RF et les sorties I, Q.

Il existe donc un besoin de disposer de générateurs IQ (ou combineurs IQ), notamment différentiels, aux fréquences RF (0,1-5GHz et au-delà) ne présentant pas ces inconvénients.

### Résumé de l'invention :

A cet effet, suivant un premier aspect, la présente invention décrit un dispositif RadioFréquence générateur de signaux en quadrature IQ comprenant une première borne d'extrémité, quatre premières branches nommées $BR1_0$, $BR1_1$, $BR1_2$, $BR1_3$ reliées à ladite première borne d'extrémité,

> chaque première branche comporte une capacité, respectivement $C_0$, $C_1$, $C_2$, $C_3$, de même capacitance, comportant une première borne et une deuxième borne, ladite deuxième borne de la capacité étant reliée à la masse et un interrupteur disposé entre la première borne d'extrémité et la première borne de la capacité de ladite première branche ;
>
> ledit dispositif étant adapté pour, dans chaque première branche $BR1_i$, fermer l'interrupteur à chaque instant $pT_0$ + (i) $T_0/4$, pendant un intervalle de temps $T_0/4$, où p est un entier naturel et $T_0$ la période du signal d'horloge;
>
> ledit dispositif étant caractérisé en ce que :
>
>> le dispositif de type NPF comprend au moins une paire de deuxièmes branches comprenant deux deuxièmes branches successives dans une liste ordonnée cyclique de quatre deuxièmes branches $BR2_0$, $BR2_1$, $BR2_2$, $BR2_3$, la deuxième branche $BR2_k$ comprenant une deuxième borne d'extrémité $E2_k$, et
>>
>> chaque deuxième branche $BR2_k$ du dispositif comprend, pour chaque première branche, $BR1_i$, i = 0 à 3, un interrupteur entre la première borne de la capacité $C_i$ de ladite première branche et ladite deuxième branche, ledit dispositif étant adapté pour fermer ledit interrupteur à chaque instant $pT_0 + (i + k)\ T_0/4$, pendant un intervalle de

temps $T_0/4$ ;

ledit dispositif RadioFréquence générateur de signaux en quadrature IQ étant adapté pour recevoir en entrée un signal d'entrée de fréquence $f_{RF}$ sur ladite première borne d'extrémité, pour générer au moins deux signaux en quadrature, de fréquence $f_{RF}$, à partir du signal

d'entrée et pour les délivrer en sortie sur les deuxièmes bornes d'extrémité de ladite paire de deuxièmes branches ;

lesdites deuxièmes bornes d'extrémité des deuxièmes branches de ladite paire étant distinctes de ladite première borne d'extrémité,

les fréquences $f_{RF}$ et $1/T_0$ étant sensiblement égales ;

pour chaque deuxième borne du dispositif : le signal délivré en sortie sur ladite deuxième borne du dispositif est lié au signal d'entrée par une fonction de transfert comprenant une fonction de filtre et une fonction de déphasage.

Ainsi l'invention se fonde sur l'exploitation d'une base de filtres dits à N-chemins (en anglais « N-Path Filters »), nommés NPF et correspondant à *N* capacités parallèles commutées par des signaux d'horloge de rapport cyclique 1/N. L'architecture de type NPF génère (ou inversement combine) *N* signaux équilibrés en amplitude, de période $T_0$, retardés l'un par rapport à l'autre de $T_0/N$. L'architecture réduit les pertes : approximativement de 1,8dB par chemin (à comparer aux 3 dB de pertes par chemin des filtres PPF-I et PPF-II) et offre naturellement un filtrage fréquentiel à fort facteur de qualité.

Elle ne nécessite ni résistance, ni inductance, ce qui réduit l'encombrement comparativement aux déphaseurs de l'art antérieur.

Dans des modes de réalisation, un tel dispositif comprend quatre deuxièmes branches $BR2_0$, $BR2_1$, $BR2_2$, $BR2_3$ comprenant chacune une deuxième borne d'extrémité respectivement $E2_0$, $E2_1$, $E2_2$ et $E2_3$ et

chaque deuxième branche $BR2_k$, k = 0 à 3, comprend, pour chaque première branche, $BR1_i$, i = 0 à 3, un interrupteur entre la première borne de la capacité $C_i$ de ladite première branche et ladite deuxième branche, ledit dispositif étant adapté pour fermer ledit interrupteur à chaque instant $pT_0 + (i + k)T_0/4$, pendant un intervalle de temps $T_0/4$,

ledit dispositif étant adapté pour recevoir un signal d'entrée de fréquence $f_{RF}$ sur ladite première borne d'extrémité (E1) et pour générer quatre signaux en quadrature sous forme différentielle, $I^+, I^-, Q^+, Q^-$, délivrés sur la deuxième borne d'extrémité $E2_0$, $E2_2$, $E2_1$, $E2_3$, chacun de fréquence $f_{RF}$,

lesdites deuxièmes bornes d'extrémité $E2_0$, $E2_1$, $E2_2$ et $E2_3$ étant distinctes de ladite première borne d'extrémité ;

- il comprend en outre un filtre complexe, dont la fonction de transfert n'est pas symétrique

par rapport à zéro, et en entrée duquel les signaux délivrés aux deuxièmes bornes d'extrémité sont fournis en entrée dudit filtre complexe.

Suivant un autre aspect, l'invention décrit un procédé de génération de signaux IQ utilisant ledit dispositif selon le premier aspect de l'invention, ledit procédé comprenant les étapes suivantes :

- application d'un signal d'entrée sur ladite première borne d'extrémité,
- obtention d'au moins deux signaux en quadrature sur les deuxièmes bornes d'extrémité d'au moins lesdits deux deuxièmes branches successives.

Dans un mode de réalisation, ce procédé de génération utilisant ledit dispositif selon le premier aspect de l'invention dans la configuration indiquée où il comprend quatre deuxièmes branches $BR2_0$, $BR2_1$, $BR2_2$, $BR2_3$ comprend les étapes suivantes :

- application d'un signal d'entrée sur ladite première borne d'extrémité,
- obtention du signal différentiel $I^+$, respectivement $I^-$, $Q^+$, $Q^-$ sur la deuxième borne d'extrémité $E2_0$, respectivement $E2_2$, $E2_1$, $E2_3$.

Suivant un autre aspect, l'invention propose un procédé de combinaison de signaux IQ en quadrature utilisant le dispositif selon le premier aspect de l'invention, ledit procédé comprenant les étapes suivantes :

- application de deux signaux en quadrature, l'un sur la deuxième borne d'extrémité de l'une des deux deuxièmes branches successives, l'autre sur la deuxième borne d'extrémité de l'autre des deux deuxièmes branches successives ;
- obtention d'un signal issu de la combinaison desdits signaux en quadrature sur ladite première borne d'extrémité.

Dans un mode de réalisation, ce procédé de génération utilisant ledit dispositif selon le premier aspect de l'invention dans la configuration indiquée où il comprend quatre deuxièmes branches $BR2_0$, $BR2_1$, $BR2_2$, $BR2_3$ comprend les étapes suivantes :

- application du signal différentiel $I^+$, respectivement $I^-$, $Q^+$, $Q^-$ sur la deuxième borne d'extrémité $E2_0$, respectivement $E2_2$, $E2_1$, $E2_3$
- obtention d'un signal issu de la combinaison desdits signaux différentiels sur ladite première borne d'extrémité.

Suivant un autre aspect, l'invention propose un dispositif RadioFréquence combineur de signaux en quadrature IQ comprenant une première borne d'extrémité, quatre premières branches nommées BR10, BR11, BR12, BR13 reliées à ladite première borne d'extrémité

chaque première branche comporte une capacité, respectivement $C_0$, $C_1$, $C_2$, $C_3$, de même capacitance, comportant une première borne et une deuxième borne, ladite deuxième borne de la capacité étant reliée à la masse et un interrupteur disposé entre la première borne d'extrémité et la première borne de la capacité de ladite première branche ;

ledit dispositif étant adapté pour, dans chaque première branche $BR1_i$, fermer l'interrupteur à chaque instant $pT_0$ + (i) $T_0/4$, pendant un intervalle de temps $T_0/4$, où p est un entier naturel et $T_0$ la période du signal d'horloge;

ledit dispositif RadioFréquence combineur de signaux en quadrature IQ étant caractérisé en ce que :

le dispositif est de type NPF et comprend au moins une paire de deuxièmes branches comprenant deux branches successives dans une liste ordonnée cyclique de deuxièmes branches $BR2_0$, $BR2_1$, $BR2_2$, $BR2_3$, la deuxième branche $BR2_k$ comprenant une deuxième borne d'extrémité $E2_k$, et

chaque deuxième branche du dispositif $BR2_k$ comprend, pour chaque première branche, $BR1_i$, i = 0 à 3, un interrupteur entre la première borne de la capacité $C_i$ de ladite première branche et ladite deuxième branche, ledit dispositif étant adapté pour fermer ledit interrupteur à chaque instant $pT_0 + (i + k)\ T_0/4$, pendant un intervalle de temps $T_0/4$ ;

ledit dispositif étant adapté pour recevoir en entrée au moins deux signaux en quadrature et de fréquence $f_{RF}$, l'un sur la deuxième borne d'extrémité de l'une des deuxièmes branches de ladite paire de deuxièmes branches, l'autre sur la deuxième borne d'extrémité de l'autre des deuxièmes branches de ladite paire de deuxièmes branches, pour les combiner et pour délivrer en sortie, sur ladite première borne d'extrémité, un signal de fréquence $f_{RF}$ issu de la combinaison desdits signaux en quadrature ;

lesdites deuxièmes bornes d'extrémité des deuxièmes branches de ladite paire étant distinctes de ladite première borne d'extrémité ;

les fréquences $f_{RF}$ et $1/T_0$ étant sensiblement égales ;

chaque signal reçu en entrée sur une deuxième borne de ladite paire étant lié au signal délivré en sortie sur la première borne par une fonction de transfert comprenant une fonction de filtre et une fonction de déphasage.

Dans un mode de réalisation, un tel dispositif comprend quatre deuxièmes branches $BR2_0$, $BR2_1$, $BR2_2$, $BR2_3$ comprenant chacune une deuxième borne d'extrémité respectivement $E2_0$, $E2_1$, $E2_2$ et $E2_3$ et

chaque deuxième branche $BR2_k$, k = 0 à 3, comprend, pour chaque première branche, $BR1_i$, i = 0 à 3, un interrupteur entre la première borne de la capacité $C_i$ de ladite première branche et ladite deuxième branche, ledit dispositif étant adapté pour fermer ledit interrupteur à chaque instant $pT_0 + (i + k)T_0/4$, pendant un intervalle de temps $T_0/4$,

ledit dispositif étant adapté pour recevoir en entrée quatre signaux en quadrature sous forme différentiels, $I^+$, $I^-$, $Q^+$, $Q^-$, de fréquence $f_{RF}$, sur les deuxièmes bornes d'extrémité $E2_0$, $E2_2$, $E2_1$, $E2_3$ , pour les combiner et pour délivrer en sortie un signal de fréquence $f_{RF}$, issu de la combinaison desdits signaux différentiels sur ladite première borne d'extrémité ;

lesdites deuxièmes bornes d'extrémité $E2_0$, $E2_1$, $E2_2$ et $E2_3$ étant distinctes de ladite première borne d'extrémité,

chaque signal reçu en entrée sur une deuxième borne de ladite paire étant lié au signal délivré en sortie sur la première borne par une fonction de transfert comprenant une fonction de filtre et une fonction de déphasage.

Suivant un autre aspect, l'invention propose un procédé de combinaison de signaux IQ en quadrature utilisant le dispositif RadioFréquence combineur de signaux en quadrature IQ (10) selon l'invention, ledit procédé comprenant les étapes suivantes :

- application, en entrée du dispositif, de deux signaux en quadrature de fréquence $f_{RF}$, l'un sur la deuxième borne d'extrémité de l'une des deuxièmes branches de ladite paire, l'autre sur la deuxième borne d'extrémité de l'autre des deuxièmes branches de ladite paire ;
- obtention, en sortie du dispositif, d'un signal de fréquence $f_{RF}$, issu de la combinaison desdits signaux en quadrature sur ladite première borne d'extrémité.

Dans un mode de réalisation, un tel procédé comprend les étapes suivantes :

- application, en entrée du dispositif, de quatre signaux différentiels en quadrature $I^+$, $I^-$, $Q+$, $Q^-$ sur les deuxièmes bornes d'extrémité $E2_0$, $E2_2$, $E2_1$, $E2_3$, chacun desdits signaux étant de fréquence $f_{RF;}$
- obtention en sortie, sur ladite première borne d'extrémité, d'un signal de fréquence $f_{RF}$ issu de la combinaison desdits signaux différentiels.

**Brève description des figures** :

L'invention sera mieux comprise et d'autres caractéristiques, détails et avantages apparaîtront mieux à la lecture de la description qui suit, donnée à titre non limitatif, et grâce aux figures annexées, données à titre d'exemple.

[Fig. 1] La figure 1 comporte les schémas de filtres polyphasés de l'art antérieur pour la génération de signaux IQ ;

[Fig. 2] La figure 2 est un chronogramme des signaux électriques mis en oeuvre dans un NPF du type représenté en figure 3 ;

[Fig. 3] La figure 3 est un schéma d'une architecture d'un N-Path Filter - N-Path Mixer classique ;

[Fig. 4] La figure 4 est un chronogramme du signal $V_{RF,out,\phi=0°}$ dans un NPF du type représenté en figure 3 ;

[Fig. 5] La figure 5 modélise le circuit de la figure 8 ;

[Fig. 6] La figure 6 représente un dispositif NPF dans un mode de réalisation de l'invention, adapté pour générer et/ou combiner des signaux I, Q différentiels ;

[Fig. 7] La figure 7 est un schéma équivalent du dispositif NPF de la figure 6 ;

[Fig. 8] La figure 8 est une représentation fréquentielle de 4 signaux IQ générés dans un mode de réalisation de l'invention ;

[Fig. 9] La figure 9 est une représentation temporelle de signaux IQ différentiels générés dans un mode de réalisation de l'invention ;

[Fig. 10] La figure 10 est une représentation temporelle de signaux IQ différentiels combinés dans un mode de réalisation de l'invention ;

[Fig. 11] La figure 11 représente schématiquement un générateur IQ, un générateur IQ différentiel, un combineur IQ et un combineur IQ différentiel ;

[Fig. 12] La figure 12 illustre un cas d'utilisation d'un générateur IQ dans un mode de réalisation de l'invention ;

[Fig. 13] La figure 13 représente un dispositif NPF dans un mode de réalisation de l'invention, adapté pour générer et/ou combiner des signaux I, Q différentiels adaptée pour recevoir en entrée un signal en mode différentiel.

Des références identiques peuvent être utilisées dans des figures différentes lorsqu'elles désignent des éléments identiques ou comparables.

**Description détaillée** :

Préambule sur les N-Path Filters NPF

En préambule, quelques généralités sur les N-Path Filters NPF sont tout d'abord présentées.

Les figures 2, 3, 4 et 5 sont relatives à une architecture classique de NPF.

Sur ces figures, le signal de source, par exemple en provenance d'une antenne, est nommé $V_{RF,ant}$ et son impédance de source $R_a$. Le signal $V_{RF,in}$ est celui situé après l'impédance $R_a$ par rapport à l'antenne. L'impédance d'entrée équivalente au circuit est notée $Z_{in}$. On observera sur les figures 2 à 5 que $V_{RF,out} = V_{RF,in}$.

Un filtre NPF est un circuit électronique qui utilise N chemins, matérialisés par un nombre identique N de capacités de façon à améliorer la réjection des signaux indésirables. Il est souvent utilisé en RF pour réduire l'impact des interférences dues aux bloqueurs.

Plus spécifiquement, la figure 3 est un schéma d'une architecture d'un N-Path Filter - N-Path Mixer.

Les figures 2, 3, 4 illustrent le cas $N = 4$, avec le signal $V_{RF,ant} = A(t)cos(\omega_{RF}t + \varphi(t))$, $A(t)$ et $\varphi(t)$ modélisant respectivement la modulation d'amplitude et de phase. Par souci de simplicité, on choisit dans ce qui suit de prendre $A(t) = A$, constante, et $\varphi(t) = 0°$ dans les représentations ; les modulations étant des phénomènes lents, cela n'impacte pas la théorie. $\omega_{RF}$ est la pulsation du signal radiofréquence ; $\omega_{RF} = 2\pi f_{RF}$ où $f_{RF}$ est la fréquence du signal radiofréquence. Le filtre NPF consiste à échantillonner pendant une période $T_0/N$, le signal $V_{RF,in}$ sur chacun des chemins de façon à ne charger la capacité correspondante que pendant cet intervalle de temps. L'action est répétée sur chacun des $N$ chemins avec un délai entre les signaux de commande des échantillonneurs (interrupteurs, commutateurs) de $T_0/N$. Si $\omega_{RF}$ est proche de $\omega_0 = 2\pi f_0 = 2\pi/T_0$ alors le signal est dans la bande passante du filtre où $f_0$ est la fréquence fondamentale du signal de commande de période $T_0$ et $\omega_0$ la pulsation angulaire correspondante. On entend ici par « proche » quand la distance entre les valeurs est inférieure à la demi-bande passante du filtre Npath définie plus bas (par exemple à partir de la fonction de transfert définie au paragraphe 114). $T_{on}$ est la durée de conduction de l'horloge sur une phase.

Relativement aux figures 2 à 4 : le signal de commande de l'échantillonneur destiné à alimenter la capacité référencée $C_0$ est nommé $\varphi_0$ ; le signal de commande de l'échantillonneur destiné à alimenter la capacité référencée $C_1$ est nommé $\varphi_{90}$ ; le signal de commande de l'échantillonneur destiné à alimenter la capacité référencée $C_2$ est nommé $\varphi_{180}$ ; le signal de commande de l'échantillonneur destiné à alimenter la capacité référencée $C_3$ est nommé $\varphi_{270}$.

On retrouve aux bornes de chaque capacité $C_i$ un signal de tension, $V_{Ci}$ , dit à fréquence intermédiaire FI de pulsation $\omega_{FI} = |\omega_{RF} - \omega_0|$. Pour cette raison, les filtres NPF assurant naturellement une fonction de mélange peuvent être utilisés en tant que N-Path Mixer (NPM) dans la littérature.

La figure 2 est un chronogramme des signaux électriques ($V_{RF,in}$, $V_{RF,ant,}$ et les signaux de commandes respectifs $\varphi_0$, $\varphi_{90}$, $\varphi_{180}$, $\varphi_{270}$ des interrupteurs) mis en oeuvre dans un NPF du type représenté en figure 3 et la figure 4 est un chronogramme du signal $V_{RF,out,\phi=0°}$ dans un circuit NPF du type représenté en figure 3. On voit bien que $V_{RF,out,\phi=0°} = V_{RF,in}$

Le schéma équivalent d'un tel circuit est représenté sur la figure 5, différenciant les deux fonctions inhérentes au circuit de la figure 3 : fonction de filtrage (correspondant au bloc FLTR 110) et fonction de mélange (correspondant sensiblement au bloc MX 120).

Pour la fonction mélange, on retrouve sur le noeud $V_{BB}$, un signal de pulsation $\omega_{FI}$ modulé en amplitude et en phase par A(t) et $\varphi$(t). $V_{BB}$ représente indifféremment (c'est-à-dire, quel que soit i) la tension $V_{Ci}$ aux bornes de la capacité $C_i$.

Pour la fonction filtrage, on s'intéresse au ratio $A_{V,RF}(f_{RF}) = \frac{V_{RF,out}(f_{RF})}{V_{RF,ant}(f_{RF})}$.

Les données du schéma équivalent à la fréquence $f_{RF}$ proche de la fréquence d'horloge des interrupteurs sont les suivantes :

$R_B=\gamma_N R_L$, la résistance dynamique équivalente aux $N$ chemins parallèles,

avec $R_L$ la résistance de charge basse fréquence (exemple : celle présentée par un amplificateur de mesure),

où

$$\gamma_N = \frac{1}{N} sinc^2\left(\frac{\pi}{N}\right)$$

$Z_{in}$ est l'impédance d'entrée du circuit à la fréquence RF vue depuis l'antenne

$$Z_{in} = R_{sw} + R_B \parallel R_{sh} \qquad (\parallel \text{ signifie "en parallèle"})$$

où $R_{sh}$ représente les pertes de puissance associées à $R_a$ et à $R_{sw}$ dues à la up et down-conversion des harmoniques du signal

$$R_{sh} = \alpha_N(R_a + R_{sw})$$

où

$$\alpha_N = \frac{N.\gamma_N}{1-N.\gamma_N}$$

avec $R_{sw}$ la résistance de l'interrupteur et $R_a$ la résistance de source (ou résistance d'antenne)

$C_B=\frac{C_i}{2\gamma_N}=\frac{C_L}{2\gamma_N}$, la capacité dynamique équivalente aux $N$ capacités $C_i$ en parallèle. Quel que soit le i, $C_i = C_L$ de sorte que $2R_BC_B = R_L\ C_L$

$L_B=\frac{1}{(2\pi f_0)^2 C_B}$, l'inductance dynamique équivalente de la fonction filtrage

$V_{Ci} = A(t)\cos\left(\varphi(t) + \frac{2\pi(i-1)}{N}\right) sinc\left(\frac{\pi}{N}\right)$, la tension aux bornes de la capacité $C_i$, $\varphi(t)$ et $A(t)$ étant, pour rappel, les fonctions de modulation lentement variables. (figure 3).

On a alors la fonction de filtrage en amplitude suivante qui présente naturellement un facteur de qualité élevé :

$$\left|A_{V,RF}(f_{\mathrm{RF}})\right| = \left|\frac{V_{RF,out}(f_{RF})}{V_{RF,ant}(f_{RF})}\right| = \left|\frac{Z_{in}}{Z_{in}+R_a}\right| = \left|\frac{Z_B+R_{sw}}{Z_B+R_{sw}+R_a}\right|$$

avec

$$Z_B = \frac{j\omega_{\mathrm{RF}}L_B}{1+(j\omega_{\mathrm{RF}})^2 L_B C_B + {}^{j\omega_{\mathrm{RF}}L_B}\!/_{(R_{sh}\parallel R_B)}}$$

Un cas particulier est celui où $R_L$ est choisie de sorte à avoir une adaptation en entrée :

$$R_L = R_{L_match} = R_a \frac{1}{\gamma_N} \frac{\alpha_N \cdot (1+\rho)(1-\rho)}{\alpha_N \cdot (1+\rho)-(1-\rho)} \text{ avec } \rho = \frac{R_{sw}}{R_a}.$$

La structure à base de NPF présentera toujours sa caractéristique filtrante avec une valeur particulière pour

$$R_B = R_{B_match} = \frac{R_{sh}(R_a+R_{sw})}{R_{sh}-(R_a+R_{sw})}.$$

L'invention

C'est dans le contexte des N-Path filters que l'invention se situe. Elle propose une architecture de type NPF générant 4 signaux, échantillonnés, de période $T_0$, retardés l'un par rapport à l'autre de $T_0/4$, équilibrés en amplitude.

Par voie de réciprocité, l'invention permet aussi de répondre à la problématique inverse, à savoir combiner 4 signaux périodiques de période $T_0$ déphasés l'un par rapport à l'autre de $T_0/4$, équilibrés en amplitude.

La figure 6 représente une architecture d'un dispositif 10 de type NPF à 4 chemins dans un mode de réalisation de l'invention, qui permet la génération et la combinaison de signaux IQ différentiels.

Le dispositif NPF 10 comporte une première borne d'extrémité, E1, et quatre premières branches parallèles, $BR1_0$, $BR1_1$, $BR1_2$, $BR1_3$, reliées chacune à E1. La tension d'entrée du dispositif, $V_{RF,in}$, est appliquée à E1 et donc aux bornes de chacune de ces quatre branches.

Chacune de ces branches $BR1_i$ comporte un interrupteur (ou commutateur) 20 et une capacité $C_i$, de valeur $C_L$ (identique pour les quatre capacités), i = 0 à 3 : une borne de cet interrupteur 20 est portée à la tension $V_{RF,in}$, et l'autre borne de l'interrupteur est connectée à une première borne de cette capacité. La deuxième borne de la capacité est reliée à la masse.

L'interrupteur 20 connecté à la capacité $C_i$ , i = 0 à 3, est commandé par un signal de commande nommé $\varphi_{90x(i)}$ (i.e. $\varphi_0$ pour i = 0, $\varphi_{90}$ pour i = 1, $\varphi_{180}$ pour i = 2, $\varphi_{270}$ pour i = 3 ) qui le fait se fermer à chaque instant $pT_0$ + (i) $T_0/4$ et ce pendant un intervalle de temps $T_0/4$, où p est un entier naturel variant de 0 à P, l'interrupteur étant ouvert sinon. Px$T_0$ est le temps de fonctionnement du dispositif, qui peut atteindre par exemple plusieurs minutes (plus de 2/5/10 min par exemple) et $T_0$ prend des valeurs variables, par exemple notamment dans une plage de 0,04 à 10 $\mu$s.

Le dispositif NPF 10 présente donc 4 chemins : en effet, il comporte quatre capacités $C_i$, i= 0 à 3.

Chaque capacité $C_i$ est ainsi sélectivement chargée par le signal d'entrée du dispositif, $V_{RF,in}$, à l'instant $pT_0$ + (*i*) $T_0/4$, pendant un intervalle de temps $T_0/4$, à l'aide de l'interrupteur 20 respectif disposé en amont de chaque capacité et piloté par le signal de commande $\varphi_{90x(i)}$ .

Le dispositif NPF 10 comporte quatre deuxièmes branches parallèles, $BR2_k$, k = 0 à 3. La résistance RL représente la charge du circuit mise en sortie du dispositif 10.

La tension $V_{Ci}$ aux bornes de $C_i$, i = 0 à 3, est appliquée aux bornes successivement de chacune de ces quatre branches $BR2_0$, $BR2_1$, $BR2_2$, $BR2_3$ pendant un intervalle de temps $T_0/4$, à des instants spécifiques, à l'aide d'interrupteurs 20 respectifs pilotés par les signaux de commande $\varphi_{90x(i),}$ comme décrit ci-dessous.

La tension, $V_{Ci}$, aux bornes de la capacité $C_i$ est ainsi sélectivement appliquée sur la branche $BR2_k$ à chaque instant $pT_0 + (i + k)T_0/4$, pendant un intervalle de temps $T_0/4$. Les signaux de commande correspondants sont indiqués au niveau des interrupteurs sur la figure 6.

La valeur de la tension aux bornes de $C_i$ est lue 4 fois, pendant un intervalle de temps $T_0/4$, tous les $pT_0 + kT_0/4$ où $k \in [0; 3]$, en commençant, pour la branche $BR2_0$, à l'instant $pT_0$ + (*i*) $T_0/4$.

Le dispositif 10 comporte 4 deuxièmes bornes d'extrémité, $E2_0$, $E2_1$, $E2_2$ et $E2_3$.

$V_{RF,out,\phi=0°}$ est le signal de tension sur la branche $BR2_0$ (aux bornes de la résistance RL de cette branche, en $E2_0$) ;

$V_{RF,out,\phi=90°}$ est le signal de tension sur la branche $BR2_1$ (aux bornes de la résistance RL de cette branche, en $E2_1$) ;

$V_{RF,out,\phi=180°}$ est le signal de tension sur la branche $BR2_2$ (aux bornes de la résistance RL de cette branche, en $E2_2$) ;

$V_{RF,out,\phi=270°}$ est le signal de tension sur la branche $BR2_3$ (aux bornes de la résistance RL de cette branche, en $E2_3$) ;

La phase nommée $V_{RF,out,\phi=2k\pi/4=360°k/4}$ est la version retardée de $kT_0/4$ (retard de phase de 360°*k*/4) du signal $V_{RF,in}$, c'est-à-dire la version retardée de $kT_0/4$, et filtrée et échantillonnée, du signal $V_{RF,ant}$.

Les chronogrammes de la tension $V_{RF,out,\phi=360°k/4}$ sont représentés en regard du point $E2_k$ à cette tension sur la figure 6, pour k = 0 à 3.

Le signal $V_{RF,out,\phi0=0°}$ est particulier dans ce sens où il reproduit le signal $V_{RF,in}$ sans délai car l'interrupteur permettant de transférer des charges de la capacité vers $R_L$ est ouvert en même temps que l'interrupteur permettant de charger la capacité. Toutefois, le temps de décharge $R_L. C_i = R_L. C_L$ étant très grand devant $T_0$ (par exemple plus de 10 fois plus grand), le fait de décharger la capacité en même temps qu'on la charge a un impact similaire à celui de la décharger durant une durée identique de $T_0/4$ mais sans qu'elle ne soit chargée pendant cet instant, ce qui est le cas pour les trois autres signaux. On a ainsi généré 4 signaux de période $T_0$, échantillonnés, retardés l'un par rapport à l'autre de $T_0/4$ , naturellement équilibrés en amplitude.

L'invention permet de répondre à la problématique particulière suivante : la génération de 2 signaux déphasés de 90° *(IQ* Generator), comme représenté en figure 11 sous forme de signaux différentiels *I+, I-, Q+, Q* - où :

$$I^+ = V_{RF,out,\phi=0°}$$

$$I^- = V_{RF,out,\phi=180°}$$

$$Q^+ = V_{RF,out,\phi=90°}$$

$$Q^- = V_{RF,out,\phi=270°} \cdot$$

Afin de valider le modèle, de vérifier l'égalité de l'amplitude des gains en tension $|A_{V,RF,\phi k}(f_{RF})|$ pour $\phi = 0$ (charge et décharge pendant le même cycle) et $\phi \neq 0$ (charge et décharge pendant un cycle différent), ainsi que l'équi-répartition des délais, deux cas ont été étudiés en fonction de la capacité $C_i$ et sont illustrés figures 8 et 9 pour lesquelles les sorties $V_{RF,out,\phi k}(f_{RF})$ sont chargées par une haute impédance $R_L = 100k\Omega$. Les valeurs des paramètres sont précisées en légende.

La figure 8 est une représentation fréquentielle de 4 signaux IQ générés dans un mode de réalisation de l'invention, révélant l'équilibrage des amplitudes et les propriétés filtrantes : les 4 phases de sorties sont bien équilibrées autour de la fréquence centrale du filtre. Tout comme pour les NPF, les propriétés filtrantes sont liées à la valeur de la capacité $C_i = C_L$.

La figure 9 est une représentation temporelle de 2 signaux IQ différentiels générés par l'invention, montrant l'équilibrage des délais sur les chronogrammes : les 4 phases de sortie présentent bien un délai de $\frac{T_0}{4}$ l'une par rapport à l'autre, correspondant à un déphasage de 90°. Ainsi on retrouve les signaux 1 et Q différentiels suivants :

$$I^+ = V_{RF,out,\phi=0°}$$

$$I^- = V_{RF,out,\phi=180°}$$

$$Q^+ = V_{RF,out,\phi=90°}$$

$$Q^- = V_{RF,out,\phi=270°} \cdot$$

Le schéma équivalent d'un tel circuit est représenté sur la figure 7, différenciant les deux fonctions de filtrage (bloc FLTR 210) et de déphasage (bloc DEcp 220) inhérentes au circuit de la figure 6.

Pour la fonction déphasage, on s'intéresse au ratio $A_{V,RF,\phi_k}(f_{RF}) = \frac{V_{RF,out,\phi_k}(f_{RF})}{V_{RF,ant}(f_{RF})} = \frac{V_{RF,out,\phi_k}(f_{RF})}{V_{RF,in}(f_{RF})} \cdot \frac{V_{RF,in}(f_{RF})}{V_{RF,ant}(f_{RF})}$ qui intègre naturellement les propriétés de filtrage du NPF.

Les données du schéma équivalent sont les suivantes :

$R_B = \gamma_N R'_L$ , la résistance équivalente aux *N* (avec N=4) chemins déphasés en parallèle.

où $R_L' = R_L + R_{sw}$ , est la somme de la résistance de charge basse fréquence (exemple : celle présentée par un amplificateur de mesure) et de la résistance $R_{sw}$ de chacun des interrupteurs situés après la capacité.
où

$$\gamma_N = \frac{1}{N} sinc^2\left(\frac{\pi}{N}\right)$$

$Z_{in}$ est l'impédance d'entrée du circuit à la fréquence RF vue depuis l'antenne

$$Z_{in} = R_{sw} + R_B \parallel R_{sh}$$

où $R_{sh}$ représente les pertes de puissance associées à $R_a$ et à $R_{sw}$ dues à la up et down-conversion des harmoniques du signal

$$R_{sh} = \alpha_N(R_a + R_{sw})$$

où

$$\alpha_N = \frac{N.\gamma_N}{1-N.\gamma_N}$$

avec $R_{sw}$ la résistance de l'interrupteur et $R_a$ la résistance de source (ou résistance d'antenne)

$C_B = \frac{C_i}{2\gamma_N} = \frac{C_L}{2\gamma_N}$ , la capacité dynamique équivalente aux $N$ capacités $C_i$ en parallèle. Quel que soit le i, $C_i = C_L$ de sorte que $2R_BC_B = R_L'C_L$

$L_B = \frac{1}{(2\pi f_0)^2 C_B}$ , l'inductance dynamique équivalente de la fonction filtrage

$V_{Ci} = A(t)\cos\left(\varphi(t) + \frac{2\pi(i-1)}{N}\right) sinc\left(\frac{\pi}{N}\right)$ , la tension aux bornes de la capacité $C_i$, $\varphi(t)$ et $A(t)$ étant, pour rappel, les fonctions de modulation lentement variables (figure 6).

On a la fonction de déphasage suivante $\forall k \in [1; N = 4]$, à la fréquence $f_{RF}$ proche de la fréquence d'horloge des interrupteurs (cf. plus haut ce qui est entendu par proche), i.e. ces fréquences sont sensiblement égales :

$$\left|A_{V,RF,\phi_k}(f_{\mathrm{RF}})\right| = \left|\frac{V_{RF,out,\phi_k}(f_{RF})}{V_{RF,ant}(f_{RF})}\right| = \left|\frac{V_{RF,out,\phi_k}(f_{RF})}{V_{RF,in}(f_{RF})}\right| \cdot \left|\frac{V_{RF,in}(f_{RF})}{V_{RF,ant}(f_{RF})}\right|$$

avec

$$\left|\frac{V_{RF,\mathrm{in}}(f_{RF})}{V_{RF,ant}(f_{RF})}\right| = \left|\frac{Z_{in}}{Z_{in}+R_a}\right| = \left|\frac{Z_B+R_{sw}}{Z_B+R_{sw}+R_a}\right|$$

et

$$\left|\frac{V_{RF,out,\phi_k}(f_{RF})}{V_{RF,in}(f_{RF})}\right| = \frac{R_L}{R_L+R_{sw}} \cdot \left|\frac{Z_B}{Z_B+R_{sw}}\right|$$

et

$$Z_B = \frac{j\omega_{RF}L_B}{1+(j\omega_{RF})^2 L_B C_B + {j\omega_{RF}L_B}/{(R_{sh}\|R_B)}}$$

Soit:

$$\left|A_{V,RF,\phi_k}(f_{RF})\right| = \left|\frac{V_{RF,out,\phi_k}(\omega_{RF})}{V_{RF,ant}(\omega_{RF})}\right| = \frac{R_L}{R_L+R_{sw}} \cdot \left|\frac{Z_B}{Z_B+R_{sw}+R_a}\right|$$

Par voie de réciprocité, l'architecture telle que représentée en figure 6 permet de répondre à la problématique inverse : la combinaison de 2 signaux différentiels en quadrature (figure 11). Les signaux correspondants sont représentés en figure 10, dans un cas où les 4 entrées sont alimentées par 4 antennes, d'impédance $R_a = 50\Omega$. La sortie est haute impédance $R_L = 100k\Omega$. Les entrées sont respectivement :

$I^+$ sur l'entrée $V_{RF,ant,0°}$
$I^-$ sur l'entrée $V_{RF,ant,180°}$
$Q^+$ sur l'entrée $V_{RF,ant,90°}$
$Q^-$ sur l'entrée $V_{RF,ant,270°}$ .

La figure 12 illustre une génération de signaux IQ à la fréquence RF dans un mode de réalisation de l'invention et d'exploitation des signaux I et Q pour implémenter un filtre complexe 83 (cf. K. W. Martin, "Complex signal processing is not complex," in IEEE Transactions on Circuits and Systems I: Regular Papers, vol. 51, no. 9, pp. 1823-1836, Sept. 2004, doi: 10.1109/CSI.2004.834522). Le premier bloc est un générateur de signaux IQ mettant en oeuvre les fonctions types de générateur IQ telles qu'illustrées par exemple le générateur 81 (ou alternativement 81') de la figure 11, et implémenté selon l'invention. Les signaux de sortie peuvent donc être différentiels ou non. Le bloc suivant 83 est un filtre complexe dont la fonction de transfert n'est pas symétrique par rapport à zéro. Il peut être un filtre à N-chemins ou un filtre à temps continu (sans horloge). L'avantage par rapport à un filtre réel est qu'il est plus facile de contrôler indépendamment la fréquence centrale et la bande passante. De plus, un filtre complexe peut présenter une meilleur réjection des signaux qu'un filtre réel.

Dans un générateur IQ selon l'invention, quelle que soit la configuration retenue (i.e. à deux branches de sortie ou à quatre branches de sortie), les signaux de sortie délivrés sur les bornes d'extrémité $E2_i$ des branches de sortie sont fonction du signal d'entrée appliqué sur la borne d'entrée E1 et sont de même fréquence que ce signal d'entrée.

Dans un générateur IQ selon l'invention, quelle que soit la configuration retenue (i.e. à deux branches de sortie ou à quatre branches de sortie), les bornes de sortie du dispositif sont distinctes (électriquement) de la borne d'entrée (ou des bornes d'entrée dans le cas d'une entrée différentielle). Dit autrement, une borne de sortie du générateur IQ ne peut être en même temps une borne d'entrée du générateur IQ.

Similairement, dans un combineur IQ selon l'invention, quelle que soit la configuration retenue (i.e. à deux branches d'entrée ou à quatre branches d'entrée), une borne de sortie du combineur IQ ne peut être en même temps une borne d'entrée du combineur IQ.

On notera que dans un dispositif selon l'invention, dans sa fonction de combineur IQ ou dans sa fonction de générateur IQ, la constante RC de chacun des circuits de charge est très grande par rapport à $T_0/4$ (au moins 10 fois plus grande), soit en considérant par exemple ici que la résistance du chaque interrupteur du montage est $R_{SW}$ :

$$- (R_a + R_{SW})*C_L >> T_0 ;$$

$$- (R_L + R_{SW})*C_L >> T_0 ;$$

Dans un mode de réalisation, le signal d'entrée est un signal sous forme différentielle. Dans ce cas, par rapport à la figure 6, le dispositif 10' dans un mode de réalisation de l'invention comprend notamment une borne d'entrée supplémentaire E1' et est complété de la façon représentée en figure 13.

Les avantages conférés par un dispositif NPF selon l'invention sont notamment :

- la sélectivité fréquentielle naturelle du signal radiofréquence traité, inhérente au fait d'utiliser une architecture à base de capacités commutées ;
- des récepteurs associés peu sensibles aux bloqueurs ;
- une architecture intrinsèquement accordable sur une large bande de fréquences (typiquement 0,1 GHz-5 GHz), sans détériorer les performances sur cette bande ;

- une architecture plus compacte ;
- une architecture limitant les pertes par chemin (1,8 dB).

## Revendications

**1.** Dispositif RadioFréquence (10) générateur de signaux en quadrature IQ comprenant une première borne d'extrémité (E1), quatre premières branches nommées $BR1_0$, $BR1_1$, $BR1_2$, $BR1_3$ reliées à ladite première borne d'extrémité

chaque première branche comporte une capacité, respectivement $C_0$, $C_1$, $C_2$, $C_3$, de même capacitance, comportant une première borne et une deuxième borne, ladite deuxième borne de la capacité étant reliée à la masse et un interrupteur disposé entre la première borne d'extrémité (E1) et la première borne de la capacité de ladite première branche ;
ledit dispositif (10) étant adapté pour, dans chaque première branche $BR1_i$, fermer l'interrupteur à chaque instant $pT_0$ + (i) $T_0$/4, pendant un intervalle de temps $T_0$/4, où p est un entier naturel et $T_0$ la période du signal d'horloge;
ledit dispositif (10) étant **caractérisé en ce que** :

- le dispositif de type NPF comprend au moins une paire de deuxièmes branches comprenant deux deuxièmes branches successives dans une liste ordonnée cyclique de quatre deuxièmes branches $BR2_0$, $BR2_1$, $BR2_2$, $BR2_3$, la deuxième branche $BR2_k$ comprenant une deuxième borne d'extrémité $E2_k$, et
- chaque deuxième branche $BR2_k$ du dispositif comprend, pour chaque première branche, $BR1_i$, i = 0 à 3, un interrupteur entre la première borne de la capacité $C_i$ de ladite première branche et ladite deuxième branche, ledit dispositif étant adapté pour fermer ledit interrupteur à chaque instant $pT_0 + (i + k)\ T_0/4$, pendant un intervalle de temps $T_0/4$ ;

ledit dispositif RadioFréquence (10) générateur de signaux en quadrature IQ étant adapté pour recevoir en entrée un signal d'entrée de fréquence $f_{RF}$ sur ladite première borne d'extrémité (E1), pour générer au moins deux signaux en quadrature, de fréquence $f_{RF}$, à partir du signal d'entrée et pour les délivrer en sortie sur les deuxièmes bornes d'extrémité de ladite paire de deuxièmes branches ;
lesdites deuxièmes bornes d'extrémité des deuxièmes branches de ladite paire étant distinctes de ladite première borne d'extrémité,
les fréquences $f_{RF}$ et $1/T_0$ étant sensiblement égales ;
pour chaque deuxième borne du dispositif : le signal délivré en sortie sur ladite deuxième borne du dispositif est lié au signal d'entrée par une fonction de transfert comprenant une fonction de filtre et une fonction de déphasage.

**2.** Dispositif RadioFréquence (10) générateur de signaux en quadrature IQ selon la revendication 1, comprenant quatre deuxièmes branches $BR2_0$, $BR2_1$, $BR2_2$, $BR2_3$ comprenant chacune une deuxième borne d'extrémité respectivement $E2_0$, $E2_1$, $E2_2$ et $E2_3$ et

chaque deuxième branche $BR2_k$, k = 0 à 3, comprend, pour chaque première branche, $BR1_i$, i = 0 à 3, un interrupteur entre la première borne de la capacité $C_i$ de ladite première branche et ladite deuxième branche, ledit dispositif étant adapté pour fermer ledit interrupteur à chaque instant $pT_0 + (i + k)T_0/4$, pendant un intervalle de temps $T_0/4$,
ledit dispositif étant adapté pour recevoir un signal d'entrée de fréquence $f_{RF}$ sur ladite première borne d'extrémité (E1) et pour générer quatre signaux en quadrature sous forme différentielle, $I^+, I^-, Q+, Q^-$, délivrés sur la deuxième borne d'extrémité $E2_0$, $E2_2$, $E2_1$, $E2_3$, chacun de fréquence $f_{RF}$,
lesdites deuxièmes bornes d'extrémité $E2_0$, $E2_1$, $E2_2$ et $E2_3$ étant distinctes de ladite première borne d'extrémité.

**3.** Dispositif RadioFréquence (10) générateur de signaux en quadrature IQ selon la revendication 1 ou 2, comprenant en outre un filtre complexe, dont la fonction de transfert n'est pas symétrique par rapport à zéro, et en entrée duquel les signaux délivrés aux deuxièmes bornes d'extrémité sont fournis en entrée dudit filtre complexe.

**4.** Procédé de génération de signaux en quadrature IQ utilisant le dispositif (10) RadioFréquence (10) générateur de signaux en quadrature IQ selon l'une quelconque des revendications 1 à 3, ledit procédé comprenant les étapes suivantes :

- application d'un signal d'entrée de fréquence $f_{RF}$ sur ladite première borne d'extrémité (E1),
- obtention d'au moins deux signaux en quadrature de fréquence $f_{RF}$ sur les deuxièmes bornes d'extrémité de ladite paire de deuxièmes branches.

**5.** Procédé de génération de signaux en quadrature IQ différentiels utilisant le dispositif (10) RadioFréquence (10) générateur de signaux en quadrature IQ selon la revendication 2 ou la revendication 3 lorsqu'elle est combinée avec la revendication 2, ledit procédé comprenant les étapes suivantes :

- application d'un signal d'entrée de fréquence $f_{RF}$ sur ladite première borne d'extrémité (E1),
- obtention du signal différentiel $I^+$, respectivement $I^-$, $Q^+$, $Q^-$ sur la deuxième borne d'extrémité $E2_0$, respectivement $E2_2$, $E2_1$, $E2_3$ chacun desdits signaux étant de fréquence $f_{RF}$.

**6.** Dispositif RadioFréquence combineur de signaux en quadrature IQ (10) comprenant une première borne d'extrémité (E1), quatre premières branches nommées $BR1_0$, $BR1_1$, $BR1_2$, $BR1_3$ reliées à ladite première borne d'extrémité

chaque première branche comporte une capacité, respectivement $C_0$, $C_1$, $C_2$, $C_3$, de même capacitance, comportant une première borne et une deuxième borne, ladite deuxième borne de la capacité étant reliée à la masse et un interrupteur disposé entre la première borne d'extrémité (E1) et la première borne de la capacité de ladite première branche ;
ledit dispositif (10) étant adapté pour, dans chaque première branche $BR1_i$, fermer l'interrupteur à chaque instant $pT_0$ + (i) $T_0/4$, pendant un intervalle de temps $T_0/4$, où p est un entier naturel et $T_0$ la période du signal d'horloge;
ledit dispositif RadioFréquence combineur de signaux en quadrature IQ étant **caractérisé en ce que** :

- le dispositif est de type NPF et comprend au moins une paire de deuxièmes branches comprenant deux branches successives dans une liste ordonnée cyclique de deuxièmes branches $BR2_0$, $BR2_1$, $BR2_2$, $BR2_3$, la deuxième branche $BR2_k$ comprenant une deuxième borne d'extrémité $E2_k$, et
- chaque deuxième branche du dispositif $BR2_k$ comprend, pour chaque première branche, $BR1_i$, i = 0 à 3, un interrupteur entre la première borne de la capacité $C_i$ de ladite première branche et ladite deuxième branche, ledit dispositif étant adapté pour fermer ledit interrupteur à chaque instant $pT_0 + (i + k)\ T_0/4$, pendant un intervalle de temps $T_0/4$ ;

ledit dispositif étant adapté pour recevoir en entrée au moins deux signaux en quadrature et de fréquence $f_{RF}$, l'un sur la deuxième borne d'extrémité de l'une des deuxièmes branches de ladite paire de deuxièmes branches, l'autre sur la deuxième borne d'extrémité de l'autre des deuxièmes branches de ladite paire de deuxièmes branches, pour les combiner et pour délivrer en sortie, sur ladite première borne d'extrémité (E1), un signal de fréquence $f_{RF}$ issu de la combinaison desdits signaux en quadrature ;
lesdites deuxièmes bornes d'extrémité des deuxièmes branches de ladite paire étant distinctes de ladite première borne d'extrémité ;
les fréquences $f_{RF}$ et $1/T_0$ étant sensiblement égales ;
chaque signal reçu en entrée sur une deuxième borne de ladite paire étant lié au signal délivré en sortie sur la première borne par une fonction de transfert comprenant une fonction de filtre et une fonction de déphasage.

**7.** Dispositif RadioFréquence combineur de signaux en quadrature IQ (10) selon la revendication 6, comprenant quatre deuxièmes branches $BR2_0$, $BR2_1$, $BR2_2$, $BR2_3$ comprenant chacune une deuxième borne d'extrémité respectivement $E2_0$, $E2_1$, $E2_2$ et $E2_3$ et

chaque deuxième branche $BR2_k$, k = 0 à 3, comprend, pour chaque première branche, $BR1_i$, i = 0 à 3, un interrupteur entre la première borne de la capacité $C_i$ de ladite première branche et ladite deuxième branche, ledit dispositif étant adapté pour fermer ledit interrupteur à chaque instant $pT_0 + (i + k)T_0/4$, pendant un intervalle de temps $T_0/4$,
ledit dispositif étant adapté pour recevoir en entrée quatre signaux en quadrature sous forme différentiels, $I^+$, $I^-$, $Q^+$, $Q^-$, de fréquence $f_{RF}$, sur les deuxièmes bornes d'extrémité $E2_0$, $E2_2$, $E2_1$, $E2_3$, pour les combiner et pour délivrer en sortie un signal de fréquence $f_{RF}$, issu de la combinaison desdits signaux différentiels sur ladite première borne d'extrémité (E1) ;
lesdites deuxièmes bornes d'extrémité $E2_0$, $E2_1$, $E2_2$ et $E2_3$ étant distinctes de ladite première borne d'extrémité, chaque signal reçu en entrée sur une deuxième borne de ladite paire étant lié au signal délivré en sortie sur la première borne par une fonction de transfert comprenant une fonction de filtre et une fonction de déphasage.

**8.** Procédé de combinaison de signaux IQ en quadrature utilisant le dispositif RadioFréquence combineur de signaux en quadrature IQ (10) selon la revendication 6, ledit procédé comprenant les étapes suivantes :

- application, en entrée du dispositif, de deux signaux en quadrature de fréquence $f_{RF}$, l'un sur la deuxième borne d'extrémité de l'une des deuxièmes branches de ladite paire, l'autre sur la deuxième borne d'extrémité de l'autre des deuxièmes branches de ladite paire ;
- obtention, en sortie du dispositif, d'un signal de fréquence $f_{RF}$, issu de la combinaison desdits signaux en quadrature sur ladite première borne d'extrémité (E1).

**9.** Procédé de combinaison de signaux IQ en quadrature utilisant le dispositif RadioFréquence combineur de signaux en quadrature IQ (10) selon la revendication 7, ledit procédé comprenant les étapes suivantes :

- application, en entrée du dispositif, de quatre signaux différentiels en quadrature $I^+$, $I^-$, $Q+$, $Q^-$ sur les deuxièmes bornes d'extrémité $E2_0$, $E2_2$, $E2_1$, $E2_3$ , chacun desdits signaux étant de fréquence $f_{RF}$ ;
- obtention en sortie, sur ladite première borne d'extrémité (E1), d'un signal de fréquence $f_{RF}$ issu de la combinaison desdits signaux différentiels.

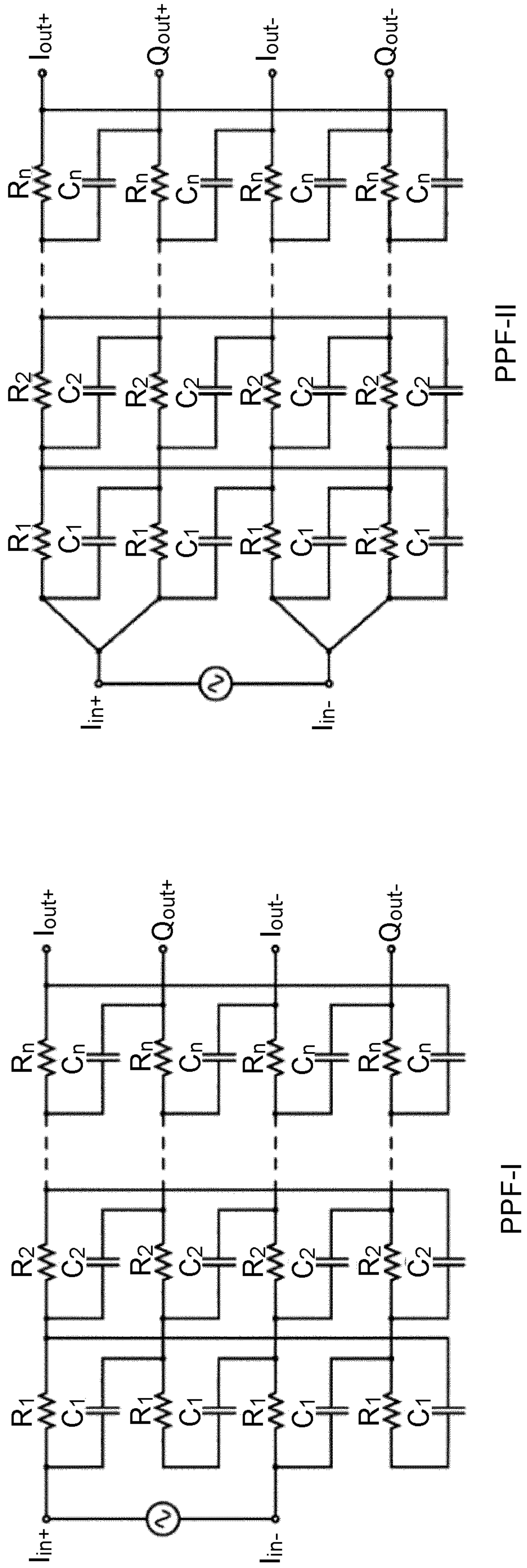


FIG.1 - AA

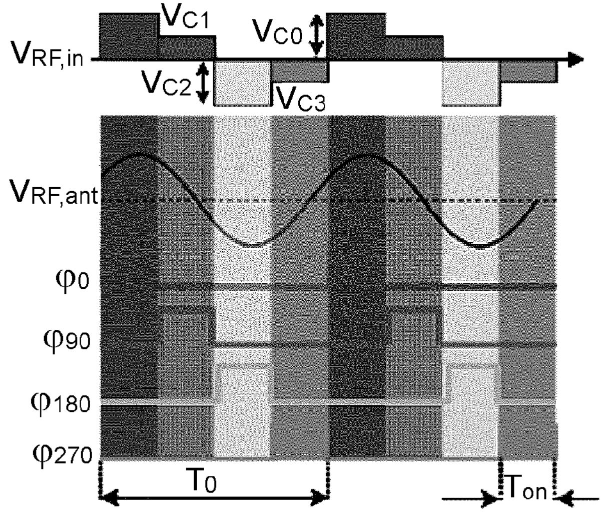


FIG.2 - AA

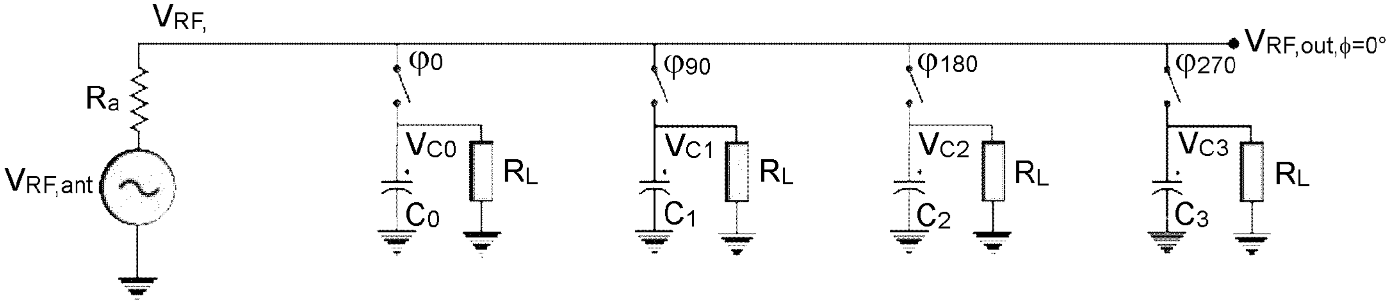


FIG.3 - AA

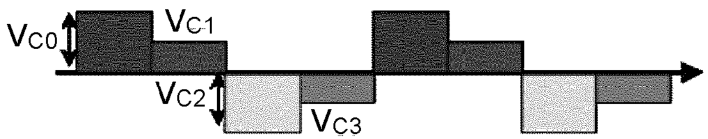


FIG.4 - AA

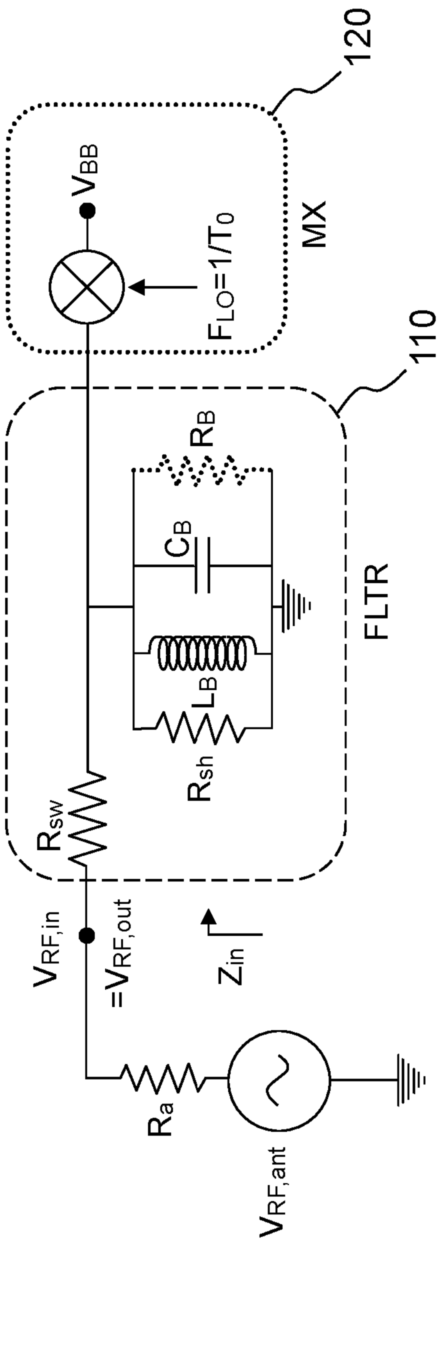
120
110
$V_{BB}$
$F_{LO}=1/T_0$
MX
$R_B$
$C_B$
FLTR
$L_B$
$R_{sh}$
$R_{sw}$
$V_{RF,in}$
$=V_{RF,out}$
$Z_{in}$
$R_a$
$V_{RF,ant}$

FIG.5 - AA

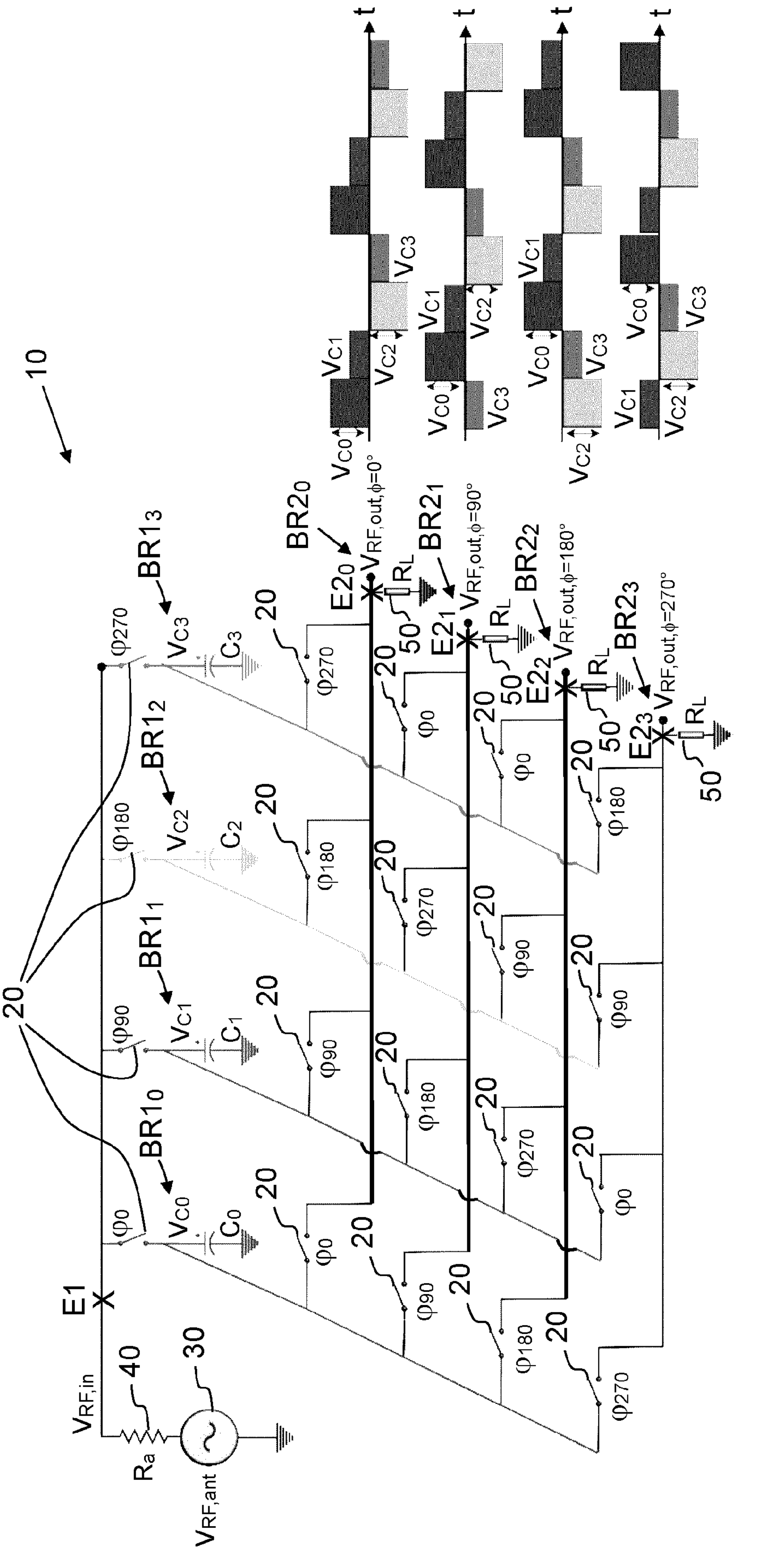
10
20
BR1$_0$
BR1$_1$
BR1$_2$
BR1$_3$
BR2$_0$
BR2$_1$
BR2$_2$
BR2$_3$
E1
E2$_0$
E2$_1$
E2$_2$
E2$_3$
$V_{RF,in}$
$V_{RF,ant}$
Ra
40
30
50
$R_L$
$V_{RF,out,\phi=0°}$
$V_{RF,out,\phi=90°}$
$V_{RF,out,\phi=180°}$
$V_{RF,out,\phi=270°}$
$V_{C0}$
$V_{C1}$
$V_{C2}$
$V_{C3}$
$C_0$
$C_1$
$C_2$
$C_3$
$\varphi_0$
$\varphi_{90}$
$\varphi_{180}$
$\varphi_{270}$
t

FIG.6

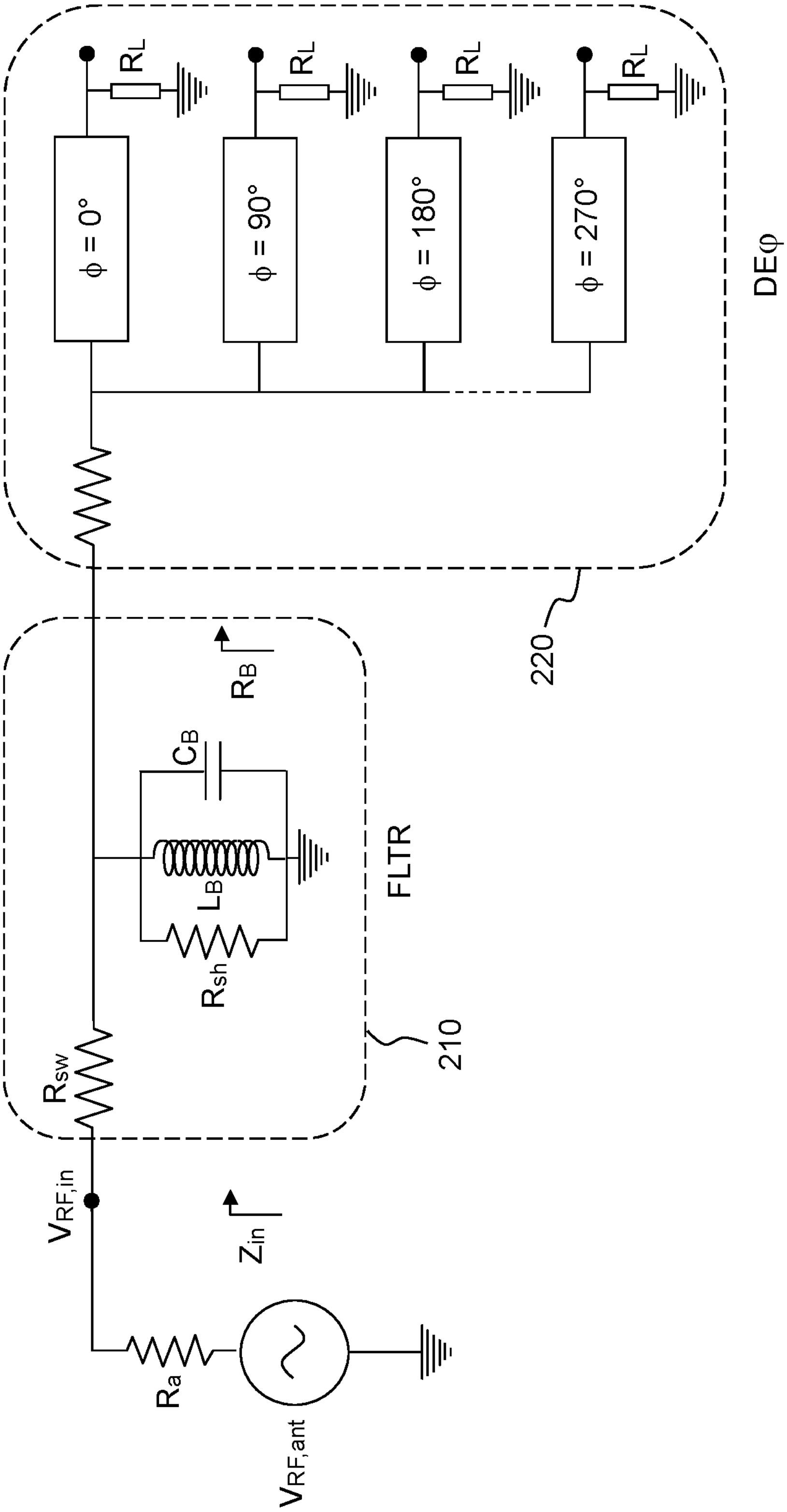

$R_L$
$R_L$
$R_L$
$R_L$
ϕ = 0°
ϕ = 90°
ϕ = 180°
ϕ = 270°
DEφ
220
$R_B$
$C_B$
$L_B$
$R_{sh}$
FLTR
210
$R_{sw}$
$V_{RF,in}$
$Z_{in}$
$R_a$
$V_{RF,ant}$


FIG.7

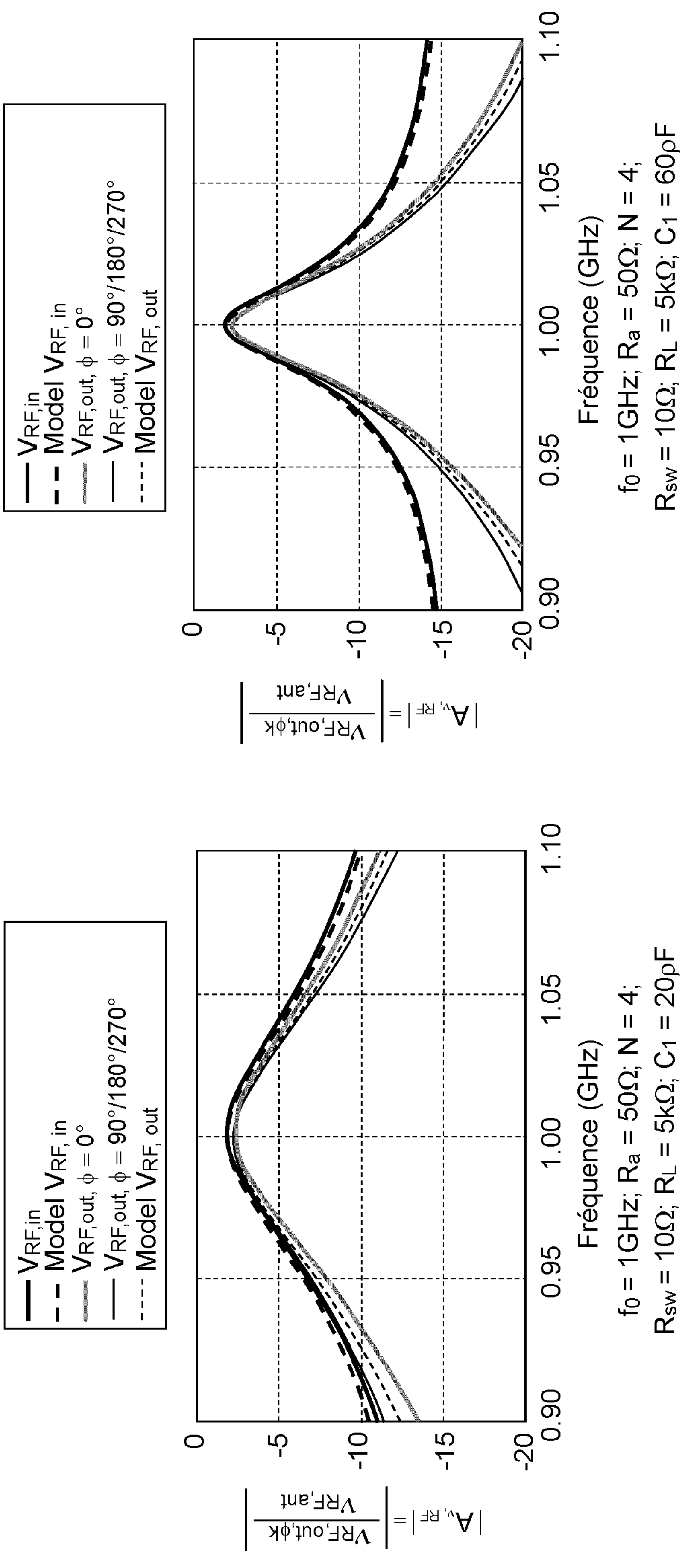

$V_{RF,in}$
Model $V_{RF,in}$
$V_{RF,out}$, φ = 0°
$V_{RF,out}$, φ = 90°/180°/270°
Model $V_{RF,out}$
$|A_{v,RF}| = \left|\frac{V_{RF,out,\phi k}}{V_{RF,ant}}\right|$
0
-5
-10
-15
-20
0.90
0.95
1.00
1.05
1.10
Fréquence (GHz)
$f_0$ = 1GHz; $R_a$ = 50Ω; N = 4;
$R_{sw}$ = 10Ω; $R_L$ = 5kΩ; $C_1$ = 20pF
$V_{RF,in}$
Model $V_{RF,in}$
$V_{RF,out}$, φ = 0°
$V_{RF,out}$, φ = 90°/180°/270°
Model $V_{RF,out}$
$|A_{v,RF}| = \left|\frac{V_{RF,out,\phi k}}{V_{RF,ant}}\right|$
0
-5
-10
-15
-20
0.90
0.95
1.00
1.05
1.10
Fréquence (GHz)
$f_0$ = 1GHz; $R_a$ = 50Ω; N = 4;
$R_{sw}$ = 10Ω; $R_L$ = 5kΩ; $C_1$ = 60pF


FIG.8

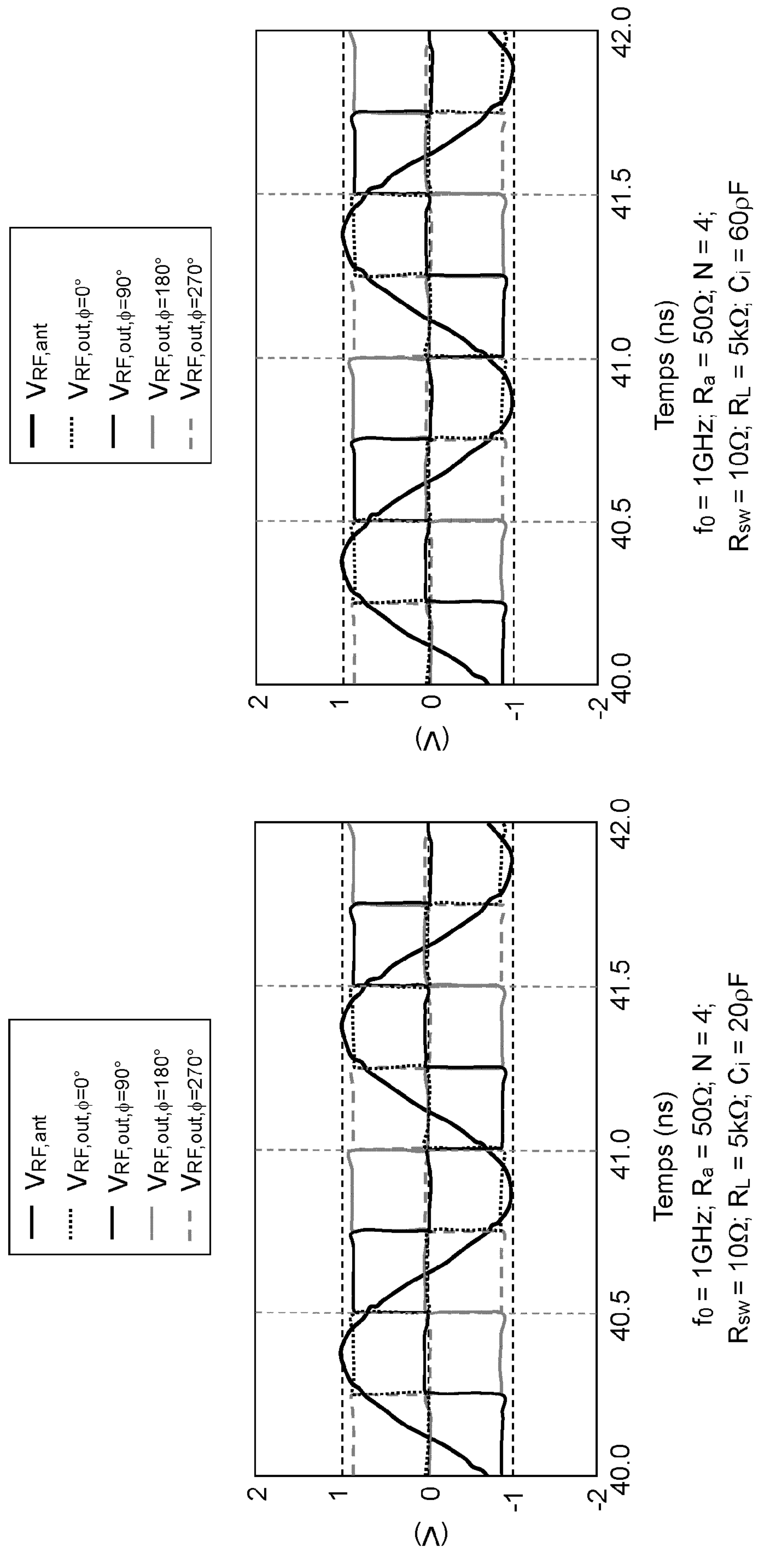
$V_{RF,ant}$
$V_{RF,out,\phi=0°}$
$V_{RF,out,\phi=90°}$
$V_{RF,out,\phi=180°}$
$V_{RF,out,\phi=270°}$
(V)
2
1
0
-1
-2
40.0
40.5
41.0
41.5
42.0
Temps (ns)
$f_0$ = 1GHz; $R_a$ = 50Ω; N = 4;
$R_{sw}$ = 10Ω; $R_L$ = 5kΩ; $C_i$ = 60ρF
$V_{RF,ant}$
$V_{RF,out,\phi=0°}$
$V_{RF,out,\phi=90°}$
$V_{RF,out,\phi=180°}$
$V_{RF,out,\phi=270°}$
(V)
2
1
0
-1
-2
40.0
40.5
41.0
41.5
42.0
Temps (ns)
$f_0$ = 1GHz; $R_a$ = 50Ω; N = 4;
$R_{sw}$ = 10Ω; $R_L$ = 5kΩ; $C_i$ = 20ρF

FIG.9

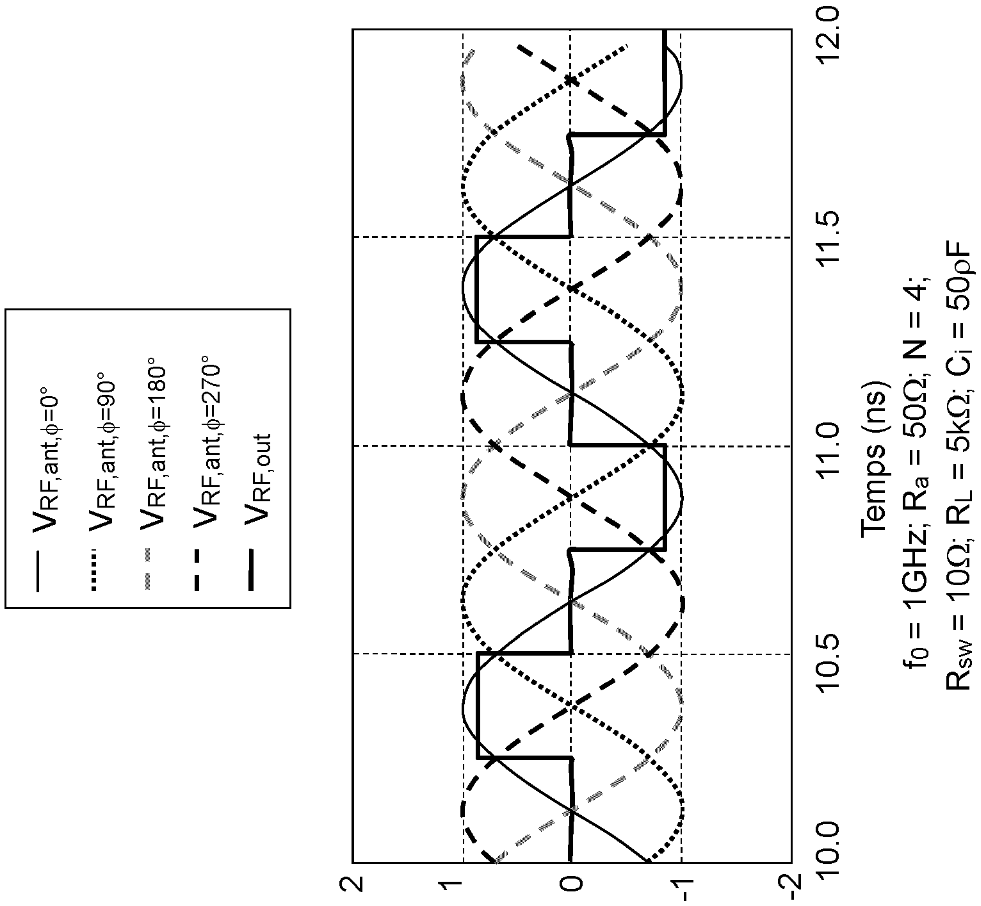
$V_{RF,ant,\phi=0°}$
$V_{RF,ant,\phi=90°}$
$V_{RF,ant,\phi=180°}$
$V_{RF,ant,\phi=270°}$
$V_{RF,out}$
(V)
2
1
0
-1
-2
10.0
10.5
11.0
11.5
12.0
Temps (ns)
$f_0$ = 1GHz; $R_a$ = 50Ω; N = 4;
$R_{sw}$ = 10Ω; $R_L$ = 5kΩ; $C_i$ = 50ρF

FIG.10

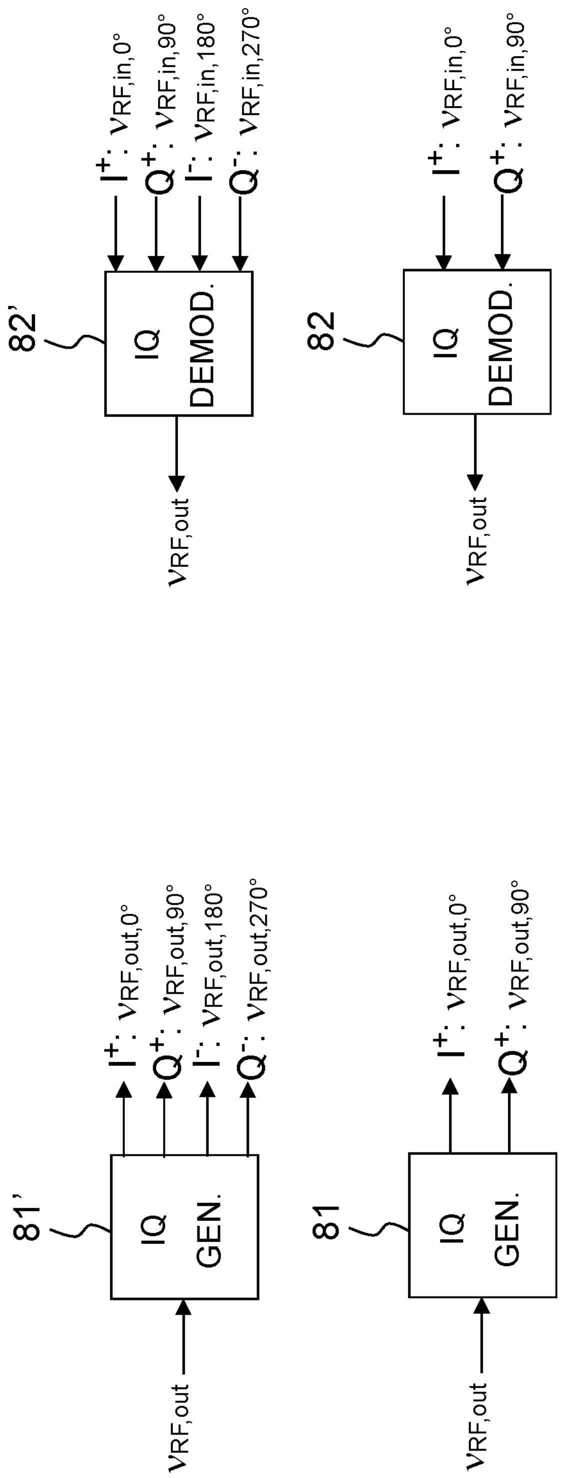

82'
IQ DEMOD.
I+: νRF,in,0°
Q+: νRF,in,90°
I-: νRF,in,180°
Q-: νRF,in,270°
νRF,out
82
IQ DEMOD.
I+: νRF,in,0°
Q+: νRF,in,90°
νRF,out
81'
IQ GEN.
νRF,out
I+: νRF,out,0°
Q+: νRF,out,90°
I-: νRF,out,180°
Q-: νRF,out,270°
81
IQ GEN.
νRF,out
I+: νRF,out,0°
Q+: νRF,out,90°


FIG.11

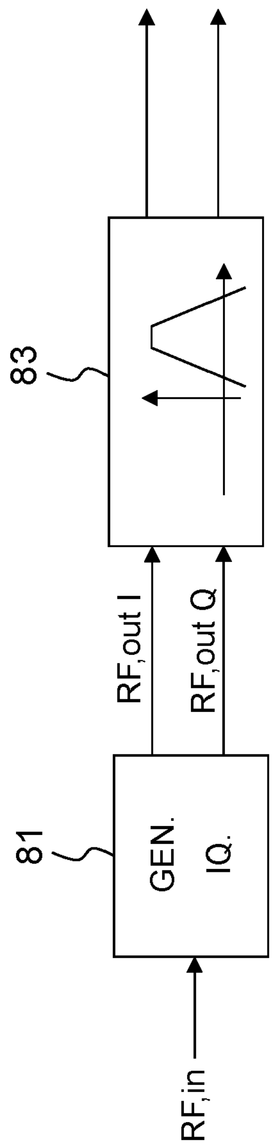


FIG.12

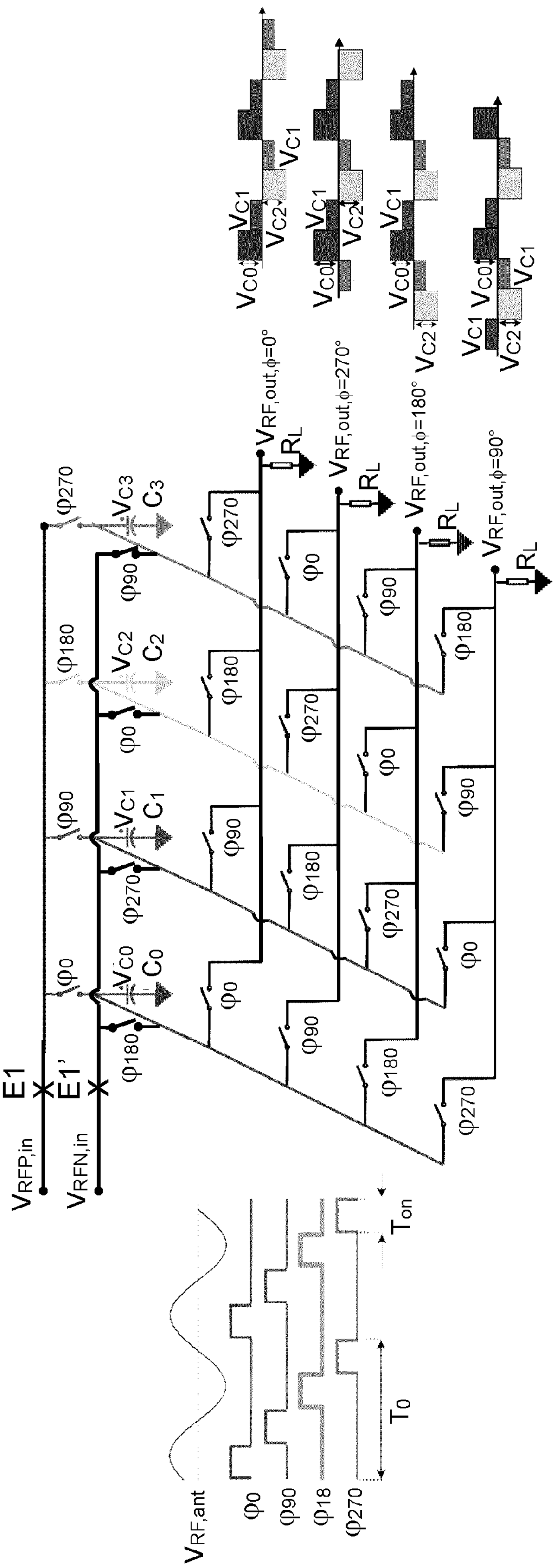
10'
V_RFP,in
V_RFN,in
E1
E1'
φ0
φ90
φ180
φ270
V_C0
C_0
V_C1
C_1
V_C2
C_2
V_C3
C_3
R_L
V_RF,out,ϕ=0°
V_RF,out,ϕ=270°
V_RF,out,ϕ=180°
V_RF,out,ϕ=90°
V_RF,ant
φ18
T_on
T_0

FIG.13

Europäisches Patentamt
European Patent Office
Office européen des brevets

# RAPPORT DE RECHERCHE EUROPEENNE

Numéro de la demande
EP 24 22 2910

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | KORD AHMED ET AL: "Microwave Nonreciprocity", PROCEEDINGS OF THE IEEE, IEEE. NEW YORK, US, vol. 108, no. 10, 31 octobre 2020 (2020-10-31), pages 1728-1758, XP011811618, ISSN: 0018-9219, DOI: 10.1109/JPROC.2020.3006041 [extrait le 2020-09-28] | 1,4,6,8 | INV. H03D7/14 H03D7/16 H03H19/00 |
| Y | * figure 32 * | 3 | |
| A | | 2,5,7,9 | |
| | ----- | | |
| A | ZEXUE LIU ET AL: "A 2.4-mW interference-resilient receiver front end with series N-path filter-based balun for body channel communication", INTERNATIONAL JOURNAL OF CIRCUIT THEORY AND APPLICATIONS, JOHN WILEY & SONS, INC, HOBOKEN, USA, vol. 46, no. 11, 19 juillet 2018 (2018-07-19), pages 2118-2133, XP071448918, ISSN: 0098-9886, DOI: 10.1002/CTA.2519 * figure 2 * | 1 | |
| | ----- | | |
| A | US 9 014 653 B2 (UNIV DELFT TECH [NL]) 21 avril 2015 (2015-04-21) * figure 6 * | 1 | |
| | ----- | | |
| | -/-- | | |

| DOMAINES TECHNIQUES RECHERCHES (IPC) |
|---|
| H03D |
| H03H |

Le présent rapport a été établi pour toutes les revendications

2

| Lieu de la recherche | Date d'achèvement de la recherche | Examinateur |
|---|---|---|
| Munich | 20 mai 2025 | Schnabel, Florian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.......................................................................................................
& : membre de la même famille, document correspondant

EPO FORM 1503 03.82 (P04C02)

page 1 de 2

Europäisches Patentamt
European Patent Office
Office européen des brevets

# RAPPORT DE RECHERCHE EUROPEENNE

Numéro de la demande
EP 24 22 2910

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y,D | MARTIN K W: "Complex Signal Processing is Not Complex", IEEE TRANSACTIONS ON CIRCUITS AND SYSTEMS PART I: REGULAR PAPERS, IEEE SERVICE CENTER, NEW YORK, NY, US, vol. 51, no. 9, 30 septembre 2004 (2004-09-30), pages 1823-1836, XP011118721, ISSN: 1057-7122, DOI: 10.1109/TCSI.2004.834522 * section IV, premier alinéa; page 1828 * ----- | 3 | |

DOMAINES TECHNIQUES RECHERCHES (IPC)

Le présent rapport a été établi pour toutes les revendications

2

| Lieu de la recherche | Date d'achèvement de la recherche | Examinateur |
|---|---|---|
| Munich | 20 mai 2025 | Schnabel, Florian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..........................................................
& : membre de la même famille, document correspondant

EPO FORM 1503 03.82 (P04C02)

## ANNEXE AU RAPPORT DE RECHERCHE EUROPEENNE RELATIF A LA DEMANDE DE BREVET EUROPEEN NO.

EP 24 22 2910

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

20-05-2025

| Document brevet cité au rapport de recherche | Date de publication | Membre(s) de la famille de brevet(s) | Date de publication |
|---|---|---|---|
| US 9014653 B2 | 21-04-2015 | US 2014077890 A1 | 20-03-2014 |
| | | US 2014080436 A1 | 20-03-2014 |
| | | US 2014085012 A1 | 27-03-2014 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description


- **J. KAUKOVUORI** ; **K. STADIUS** ; **J. RYYNANEN** ; **K. A. I. HALONEN**. Analysis and Design of Passive Polyphase Filters. *IEEE Transactions on Circuits and Systems I: Regular Papers*, November 2008, vol. 55 (10), 3023-3037
- **K. W. MARTIN**. Complex signal processing is not complex. *IEEE Transactions on Circuits and Systems I: Regular Papers*, September 2004, vol. 51 (9), 1823-1836